# EUROPEAN PATENT APPLICATION

(11) **EP 4 796 903 A1**
(43) Date of publication of application: **26.08.2026**
(21) Application number: 24879391.1
(22) Date of filing: 16.07.2024
(51) Int. Cl.: G01H 17/00, G01R 33/12

(54) **EVALUATION DEVICE AND EVALUATION METHOD**

(30) Priority: 17.10.2023 JP 2023178571
(71) Applicant: Nippon Steel Corporation, Tokyo 100-8071 (JP)
(72) Inventor: KAWAMURA, Yusuke, Tokyo 100-8071 (JP); MOGI, Hisashi, Tokyo 100-8071 (JP); MIZOKAMI, Masato, Tokyo 100-8071 (JP)
(74) Representative: Vossius & Partner Patentanwälte Rechtsanwälte mbB
(86) International application number: PCT/JP2024/025539
(87) International publication number: WO 2025/083960

(57) **Abstract**

An evaluation apparatus (100) evaluates vibration of a magnetic material. The evaluation apparatus (100) includes a magnetic core (10), a plurality of winding parts (20), and a first measurement device (31, 32, 33). The magnetic core (10) is made of the magnetic material. The magnetic core (10) includes a leg part (11). The winding parts (20) are arranged with a gap (G) therebetween in an axial direction of the leg part (11), and attached to the leg part (11) so as to expose the leg part (11) through the gap (G). The winding parts (20) are configured to excite the magnetic core (10) by excitation. The first measurement device (31, 32, 33) measures vibration of the leg part (11).

## Description

### TECHNICAL FIELD

The present disclosure relates to an evaluation apparatus and an evaluation method for evaluating the vibration of a magnetic material.

### BACKGROUND ART

It is known that, when a magnetic material is magnetized, a phenomenon called magnetostriction occurs in which the size of the magnetic material changes according to the strength of the magnetic field. For example, in the case of a device such as a transformer, an alternating magnetic field is generated in a magnetic core made of a magnetic material as a result of an alternating current flowing through an excitation coil. Accordingly, the magnetostriction (elongation and contraction) occurring in the magnetic core also cyclically fluctuates. Such a phenomenon of magnetostriction may cause vibration of the magnetic core. The vibration of the magnetic core may result in vibration and noise in a device in which the magnetic core is mounted. By evaluating the vibration of the magnetic material that forms the magnetic core, it is possible to propose a device with reduced noise.

For example, Non-Patent Literature 1 discloses measuring the vibration of a magnetic core in order to analyze the effects of a magnetic material on the noise of a transformer. In Non-Patent Literature 1, for a model transformer including a three-phase three-legged magnetic core, the vibrations of a yoke of the magnetic core, and a joined portion between the yoke and the leg parts are measured using a laser Doppler vibrometer.

Patent Literature 1 also discloses measuring the vibration of a magnetic material using a laser Doppler vibrometer. In Patent Literature 1, for example, a laser beam from the laser Doppler vibrometer is emitted to a reflection object on the magnetic material, and displacement of the magnetic material is measured. The reflection object is disposed at a position adjacent to a winding part on the magnetic material.

### CITATION LIST

### PATENT LITERATURE

Patent Literature 1: Japanese Unexamined Patent Publication No. 7-270509

### NON-PATENT LITERATURE

Non-Patent Literature 1: Seiji Okabe, et al, "Evaluation and Analysis Techniques of Transformer Performance in JFE Steel", JFE TECHNICAL REPORT, JFE Steel Corporation, August 2015, No. 36, pp. 17-23

### SUMMARY OF INVENTION

### TECHNICAL PROBLEM

In Non-Patent Literature 1 and Patent Literature 1, the vibration of the magnetic core is measured outside the winding part. In each of the literatures, vibration measurement is not performed at the leg part, or in other words, the portion to which the winding part is attached, of the magnetic core. However, it is assumed that a particularly large vibration may be generated at the leg part due to, for example, magnetization caused by the winding part, or interaction between the current flowing through the winding part and the magnetic field generated in the leg part. Therefore, it is believed that, if the vibration of the leg part can be measured, a device with reduced noise can be more easily proposed.

An object of the present disclosure is to provide an evaluation apparatus capable of measuring the vibration of a leg part to which a winding part is attached.

### SOLUTION TO PROBLEM

An evaluation apparatus according to the present disclosure evaluates vibration of a magnetic material. The evaluation apparatus includes a magnetic core, a plurality of winding parts, and a first measurement device. The magnetic core is made of the magnetic material. The magnetic core includes a leg part. The winding parts are arranged with a gap therebetween in an axial direction of the leg part, and attached to the leg part so as to expose the leg part through the gap. The winding parts are configured to excite the magnetic core by excitation. The first measurement device measures vibration of the leg part.

### ADVANTAGEOUS EFFECTS OF INVENTION

With the evaluation apparatus according to the present disclosure, it is possible to measure the vibration of a leg part to which a winding part is attached.

### BRIEF DESCRIPTION OF DRAWINGS

[FIG. 1] FIG. 1 is a plan view showing a main configuration of an evaluation apparatus according to an embodiment.
[FIG. 2] FIG. 2 is a side view of the evaluation apparatus shown in FIG. 1.
[FIG. 3] FIG. 3 is an exploded perspective view showing configurations of a magnetic core, winding parts, and a support frame included in the evaluation apparatus shown in FIGS. 1 and 2.
[FIG. 4] FIG. 4 is a flowchart for illustrating an evaluation method according to an embodiment.
[FIG. 5] FIG. 5 is a plan view showing a main configuration of an evaluation apparatus according to a modification.
[FIG. 6] FIG. 6 is a plan view showing a main configuration of an evaluation apparatus according to a modification.
[FIG. 7] FIG. 7 is a perspective view showing configurations of winding parts included in an evaluation apparatus according to a modification.

### DESCRIPTION OF EMBODIMENTS

An evaluation apparatus according to an embodiment evaluates vibration of a magnetic material. The evaluation apparatus includes a magnetic core, a plurality of winding parts, and a first measurement device. The magnetic core is made of the magnetic material. The magnetic core includes a leg part. The winding parts are arranged with a gap therebetween in an axial direction of the leg part, and attached to the leg part so as to expose the leg part through the gap. The winding parts are configured to excite the magnetic core by excitation. The first measurement device measures vibration of the leg part (First Configuration).

In the evaluation apparatus according to the first configuration, to the leg part of the magnetic core, the plurality of winding parts are attached with a gap therebetween. The leg part is exposed through the gap between the winding parts. Accordingly, for example, when the vibration of the leg part in an out-plane direction or an in-plane direction (a direction perpendicular to the axial direction of the leg part) is measured, the gap between the winding parts can be used. Therefore, it is possible to measure the vibration of the leg part to which the winding parts are attached.

Another evaluation apparatus according to an embodiment evaluates vibration of a magnetic material. The evaluation apparatus includes a plurality of winding parts, and a first measurement device. The winding parts are arranged with a gap therebetween in the axial direction thereof, and attachable to the leg part of the magnetic core made of the magnetic material. The first measurement device measures vibration of the leg part (second configuration).

In the evaluation apparatus according to the first or second configuration, each of the plurality of winding parts can include an excitation coil through which an excitation current flows (third configuration).

A large current flows through a primary-side (input-side) excitation coil and a large Lorentz force is generated therein, as compared with a secondary-side (output-side) detection coil. Accordingly, a significant vibration may be generated in the leg part of the magnetic core at a location where the excitation coil is disposed. In this respect, since each of the winding parts includes the excitation coil in the third configuration, the excitation coils are disposed with a gap therebetween at the leg part of the magnetic core. By using the gap, it is possible to measure vibration at locations of the leg part where the excitation coils are disposed, or in other words, the positions of a group of excitation coils through which a large current flows.

The evaluation apparatus according to any of the first to third configurations may further include a jig. The jig is disposed on the leg part in the gap between the winding parts, and can fix the leg part to the evaluation apparatus (fourth configuration).

For example, in a transformer, the magnetic core is used while being fixed to a part of the transformer. When a magnetic core is formed by laminating electrical steel sheets, the laminated electrical steel sheets are compressed and tightly fastened to the part of the transformer. Also at the time of measuring and evaluating the vibration of the magnetic core, it is preferable to reproduce the actual use state as close as possible. In the fourth configuration, the jig is disposed in the gap between the winding parts, and this jig fixes the leg part of the magnetic core to the evaluation apparatus. Since the jig is disposed on the leg part, a compressive force can be applied to the leg part from a surface thereof. Therefore, it is possible to reproduce the force applied to the leg part in actual use, and measure the vibration of the leg part.

In the evaluation apparatus according to the fourth configuration, the jig can include a cut-out portion. The cut-out portion is formed, for example, on a surface of the jig that opposes the leg part, and penetrates the jig in the axial direction of the leg part (fifth configuration).

In the fifth configuration, the cut-out portion is provided on the jig that fixes the leg part. Using this cut-out portion, it is also possible to measure the vibration of the leg part.

In the evaluation apparatus according to any one of the first to fifth configurations, the first measurement device may be a laser Doppler vibrometer (sixth configuration).

The evaluation apparatus according to any one of the first to sixth configurations can include a plurality of first measurement devices. In this case, each of the first measurement devices may be configured such that a position thereof relative to the leg part is adjustable (seventh configuration).

The evaluation apparatus according to any one of the first to seventh configurations may be configured to adjust an excitation waveform based on output waveform information prepared in advance, and perform excitation of the winding parts in accordance with the excitation waveform (eighth configuration).

The evaluation apparatus according to any one of the first to eighth configurations may further include a second measurement device. The second measurement device can measure information that is different from information measured by the first measurement device for the magnetic core (ninth configuration).

The evaluation apparatus according to any one of the first to ninth configurations may be configured to excite the magnetic core while varying excitation conditions, and measure vibration of the leg part by the first measurement device under each of the excitation conditions (tenth configuration).

The evaluation apparatus according to any one of the first to tenth configurations may include two first measurement devices. In this case, the first measurement devices are capable of emitting laser beams to a measurement point of the leg part from different directions. Between an emission path of a laser beam from one of the first measurement devices to the measurement point and an emission path of a laser beam from the other of the first measurement devices to the measurement point, a light-blocking plate is provided adjacent to the measurement point. The light-blocking plate prevents interference between the laser beam emitted from one of the first measurement devices and the laser beam emitted from the other of the first measurement devices (eleventh configuration).

The evaluation apparatus according to the eleventh configuration is provided with two first measurement devices. The light-blocking plate is provided between the emission path of a laser beam from one of the first measurement devices and the emission path of a laser beam from the other of the first measurement devices so as to prevent interference between the laser beams emitted from these first measurement devices to the measurement point of the leg part. Thus, the accuracy of measurement of vibration of the leg part performed by each of the first measurement devices can be improved.

An evaluation method according to an embodiment evaluates vibration of a magnetic material. The evaluation method includes the steps of: preparing a magnetic core including a leg part, and a plurality of winding parts; and exciting the magnetic core by excitation of the winding parts, and measuring vibration of the leg part by the measurement device. The magnetic core is made of the magnetic material. The winding parts are arranged with a gap therebetween in an axial direction of the leg part, and attached to the leg part so as to expose the leg part through the gap (twelfth configuration).

In the evaluation method according to the twelfth configuration, in the measuring step, vibration of the leg part may be measured by the measurement device through the gap between the winding parts (thirteenth configuration).

In the evaluation method according to the twelfth or thirteenth configuration, the magnetic core can include three leg parts. In this case, the plurality of winding parts are respectively attached to the three leg parts. Connection methods of the winding parts can be changed between the leg parts (fourteenth configuration).

In the following, embodiments of the present disclosure will be described with reference to the drawings. In the drawings, identical or equivalent components are denoted by identical reference numerals, and the same description will not be repeated.

### [Evaluation Apparatus]

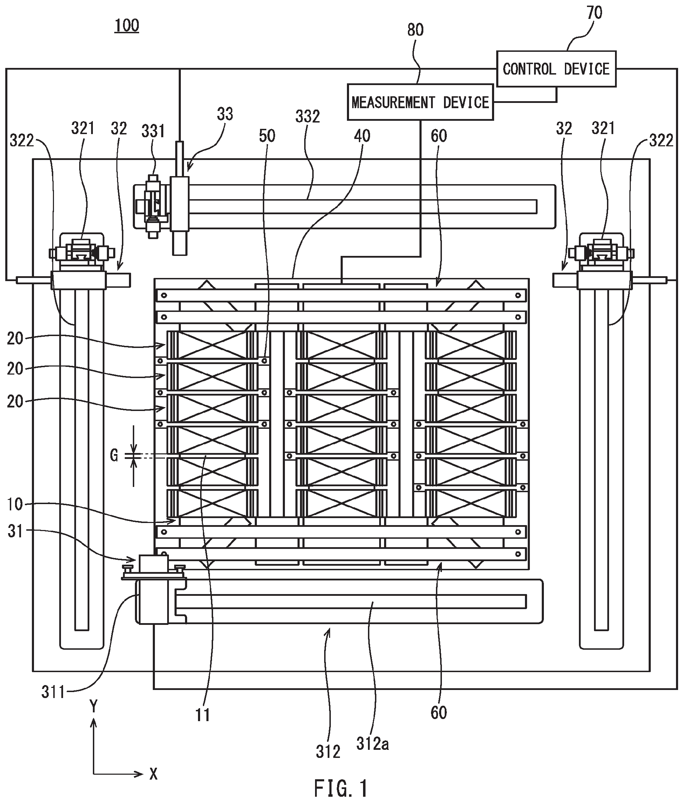

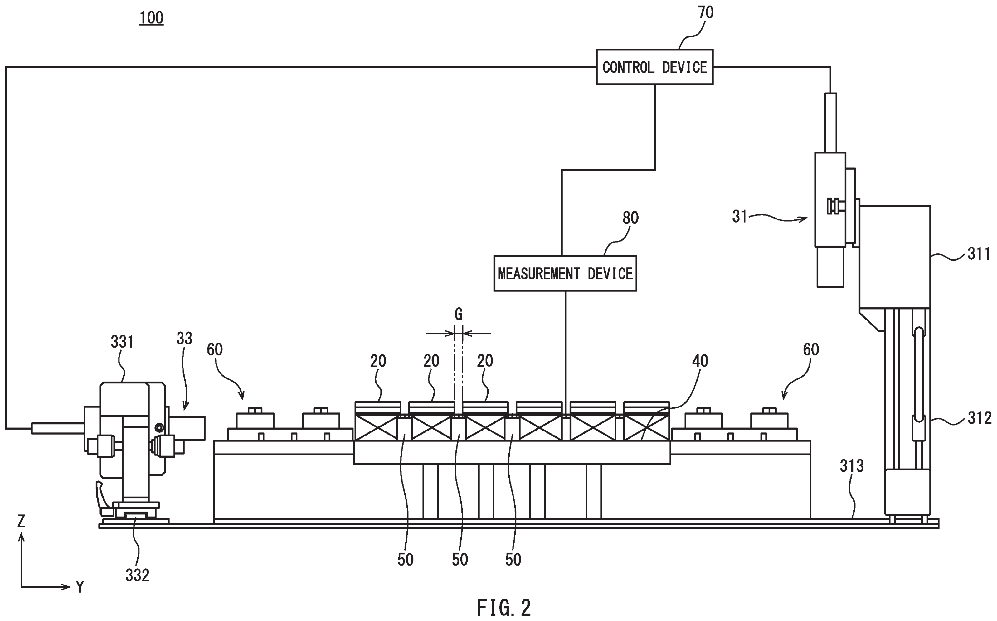

FIG. 1 is a plan view showing a main configuration of an evaluation apparatus 100 according to this embodiment. FIG. 2 is a side view of the evaluation apparatus 100 shown in FIG. 1. The evaluation apparatus 100 is used for evaluating the vibration of a magnetic material. Referring to FIGS. 1 and 2, the evaluation apparatus 100 includes a magnetic core 10 to be evaluated, a plurality of winding parts 20, and a plurality of first measurement devices 31, 32, and 33. The evaluation apparatus 100 may further include a support frame 40, jigs 50 and 60, a control device 70, and a second measurement device 80.

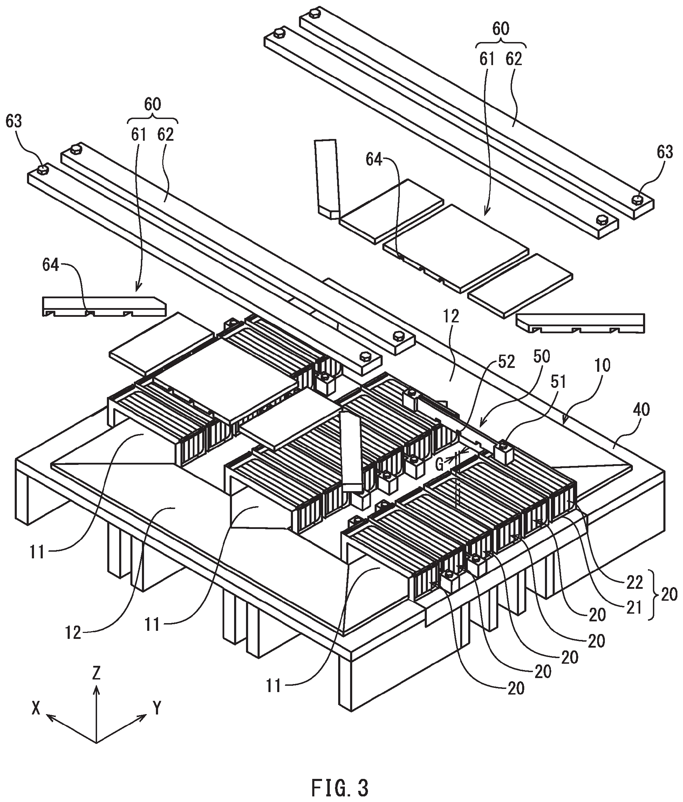

The magnetic core 10 and the winding parts 20 are supported by the support frame 40, for example. FIG. 3 is an exploded perspective view showing configurations of the magnetic core 10, the winding parts 20, and the support frame 40.

Referring to FIG. 3, the magnetic core 10 includes at least one leg part 11. In this embodiment, the magnetic core 10 includes three leg parts 11. These leg parts 11 are arranged in parallel, and coupled by yokes 12.

The magnetic core 10 is made of a magnetic material. The magnetic core 10 is, for example, a laminated iron core formed by laminating a plurality of steel sheets. More specifically, a steel sheet for the leg part 11 and a steel sheet for the yoke 12 are separate from each other in each layer, and the steel sheets are laminated such that a seam between the steel sheet for the leg part 11 and the steel sheet for the yoke 12 is located differently layer-by-layer, or by multiple layers. Typically, oriented electrical steel sheets are used for the magnetic core 10. However, non-oriented electrical steel sheets or amorphous alloy sheet may be used for the magnetic core 10. The magnetic core 10 is not limited to a laminated iron core, and may be a wound core, for example. Alternatively, the magnetic core 10 may be a dust core.

A plurality of winding parts 20 are attached to the at least one leg part 11. In the example shown in FIG. 3, a plurality of winding parts 20 are attached to each of the leg parts 11. In this embodiment, each of the winding parts 20 includes a bobbin 21 and a coil 22. The bobbin 21 is made of a non-conductive material. The bobbin 21 has a tubular shape. The leg part 11 is inserted inside the bobbin 21. In the example shown in FIG. 3, as a result of the coil 22 being independently wound around each of the plurality of bobbins 21 that are arranged at intervals, the plurality of independent winding parts 20 are formed at intervals. Each of the intervals between the plurality of winding parts 20 (bobbins 21) constitutes a portion in which no winding part is provided, and is referred to as a gap G.

The coil 22 is made of a conductive material. The coil 22 is configured to be wound around the leg part 11. In this embodiment, the coil 22 is wound around the bobbin 21. The coil 22 includes at least one of a primary-side excitation coil and a secondary-side detection coil. The coil 22 may include both the excitation coil and the detection coil. For example, the coil 22 can include an excitation coil and a detection coil that are concentrically wound around the bobbin 21. In this case, the detection coil may be disposed on the excitation coil, or the excitation coil may be disposed on the detection coil. In the coil 22, the excitation coil and the detection coil are electrically insulated from each other. Although not shown, the coil 22 may be covered by known insulating paper.

The at least one leg part 11 is provided with a plurality of winding parts 20. In this embodiment, each of the leg parts 11 is provided with a plurality of winding parts 20. For example, three or more winding parts 20 are provided for each leg part 11. On each leg part 11, when all of the plurality of winding parts 20 include excitation coils in the coils 22, these excitation coils are electrically connected in series. Similarly, on each leg part 11, when the plurality of winding parts 20 include, in addition to the excitation coils, the detection coils in the coils 22, these detection coils are electrically connected in series. As in this embodiment, the magnetic core 10 and the winding parts 20 may constitute a model of a three-phase three-legged transformer.

On the at least one leg part 11, the winding parts 20 are arranged in the axial direction (the longitudinal direction of the leg part, the Y direction of FIG. 3) of the leg part 11 with gaps G therebetween. At least one gap G is present between the winding parts 20 arranged in the axial direction of the leg part 11. The winding parts 20 are attached to the leg part 11 so as to expose the leg part 11 through the gap G between the winding parts 20. In this embodiment, three or more winding parts 20 are provided for each leg part 11, and therefore a plurality of gaps G are present between rows of the winding parts 20 on the leg part 11. The number of gaps G for each leg part 11 may be, for example, two or more, or five or more. The size of each of the gaps G in the axial direction of the leg part 11 is preferably 1 mm or more. The size of each of the gaps G in the axial direction of the leg part 11 can be, for example, 50 mm or less. The size of each of the gaps G may be 30 mm or less, and furthermore can be 10 mm or less. Hereinafter, for the sake of convenience of description, the axial direction of the leg part 11 may be referred to as a Y direction. In addition, the up-down direction on the plane of paper in FIG. 3 may be referred to as a Z direction, and the width direction (direction perpendicular to the Y direction and the Z direction) of the leg part 11 may be referred to as an X direction.

The magnetic core 10 and the winding parts 20 are placed on the support frame 40. The magnetic core 10 is fixed to the support frame 40 preferably using the jigs 50 and 60.

When the magnetic core 10 is fixed to the evaluation apparatus 100 using the jig 50, at least one jig 50 is provided for the leg part 11 including a gap G between the winding parts 20. The jig 50 is disposed on the leg part 11 in the gap G between the winding parts 20. The jig 50 has a shape corresponding to the gap G between the winding parts 20. The jig 50 is provided in the gap G between the winding parts 20 so as to traverse the leg part 11 in the X direction.

The jig 50 is fixed to the support frame 40, for example. More specifically, the jig 50 is placed on the leg part 11, and fastened to the support frame 40 on both sides in the X direction using fastening members 51 such as bolts. Thus, the leg part 11 is fixed to the evaluation apparatus 100 using the jig 50. That is, the leg part 11 is compressed between the support frame 40 and the jig 50, and the leg part 11 is tightly fastened to the support frame 40.

The jig 50 can include at least one cut-out portion 52. In the example shown in FIG. 3, the jig 50 includes a plurality of cut-out portions 52. These cut-out portions 52 are formed on a surface of the jig 50 that opposes the leg part 11. Each of the cut-out portions 52 penetrates the jig 50 in the Y direction. Each cut-out portion 52 has a groove shape extending, when the jig 50 is disposed in the gap G between two adjacent winding parts 20, from one of the winding parts 20 toward the other winding part 20.

When the magnetic core 10 is fixed to the evaluation apparatus 100 using the jigs 60, the jigs 60 are provided so as to respectively correspond to the yokes 12 of the magnetic core 10. The jigs 60 fix the yokes 12 to the support frame 40, for example. In the example shown in FIG. 3, the jigs 60 each include a jig body 61 and one or more retainer plates 62. The jig body 61 is disposed on the corresponding yoke 12. As shown in FIG. 3, the jig body 61 may be divided into a plurality of parts. The retainer plates 62 are disposed on the jig body 61. The retainer plates 62 are fastened to the support frame 40 at a plurality of locations using fastening members 63 such as bolts. Thus, the yokes 12 are fixed to the evaluation apparatus 100 using the jigs 60. That is, the yokes 12 are compressed between the support frame 40 and the jigs 60, and the yokes 12 are tightly fastened to the support frame 40.

Each jig 60 can include at least one cut-out portion 64. In the example shown in FIG. 3, the jig 60 includes a plurality of cut-out portions 64. The cut-out portions 64 are formed, for example, on a surface of the jig body 61 that opposes the corresponding yoke 12. Each of the cut-out portions 64 penetrates the jig body 61 in the Y direction. That is, each cut-out portion 64 has a groove shape extending from the yoke 12 side toward the leg part 11 side. Each cut-out portion 64 is disposed, for example, at a position corresponding to one of the cut-out portions 52 provided on the jig 50 on the leg part 11 side.

In FIGS. 1 and 2, the first measurement devices 31, 32, and 33 are measurement devices for measuring the vibration of the leg part 11 of the magnetic core 10. The first measurement devices 31, 32, and 33 can measure vibration (displacement) of the leg part 11 when the magnetic core 10 is excited. Typically, the first measurement devices 31, 32, and 33 are laser Doppler vibrometers. However, the first measurement devices 31, 32, and 33 may be other vibrometers. For example, the first measurement devices 31, 32, and 33 may be a non-contact vibrometer such as a white-light interferometric displacement meter, a capacitive displacement meter, or a laser displacement meter, or may be a contact vibrometer. The first measurement devices 31, 32, and 33 can be selected as appropriate from known vibrometers. Note that the first measurement devices 32 have been omitted from FIG. 2.

In this embodiment, the first measurement device 31 is disposed above the magnetic core 10 to be evaluated. The first measurement device 31 is configured such that a position thereof relative to the leg part 11 of the magnetic core 10 is adjustable. More specifically, the relative positional relationship between the first measurement device 31 and the leg part 11 is adjustable in the X direction and the Y direction.

Referring to FIG. 2, the first measurement device 31 is mounted to a traveling platform 312 via a mounting member 311. The first measurement device 31 may be removable from the mounting member 311. The traveling platform 312 is movable in the Y direction. The traveling platform 312 travels along a rail 313 extending in the Y direction in the vicinity of the support frame 40, for example. With the movement of the traveling platform 312 in the Y direction, the position of the first measurement device 31 relative to the leg part 11 (FIGS. 1 and 3) in the Y direction changes.

Referring to FIG. 1, the traveling platform 312 is provided so as to straddle, in the X direction, the support frame 40 that supports the magnetic core 10. The traveling platform 312 is provided with a rail 312a. The rail 312a is disposed above the magnetic core 10, and extends in the X direction. The mounting member 311 moves in the X direction along the rail 312a. With the movement of the mounting member 311 in the X direction, the position of the first measurement device 31 relative to the leg part 11 in the X direction changes.

Still referring to FIG. 1, the first measurement device 32 is configured such that a position thereof relative to the leg part 11 of the magnetic core 10 is adjustable. More specifically, in the Y direction, the relative positional relationship between the first measurement device 32 and the leg part 11 is adjustable. The first measurement device 32 is mounted to the traveling platform 321. The first measurement device 32 may be removable from the traveling platform 321. The traveling platform 321 is movable in the Y direction. The traveling platform 321 travels along a rail 322 extending in the Y direction in the vicinity of the support frame 40, for example. With the movement of the traveling platform 321 in the Y direction, the position of the first measurement device 32 relative to the leg part 11 in the Y direction changes.

The first measurement device 33 is configured such that a position thereof relative to the leg part 11 of the magnetic core 10 is adjustable. More specifically, in the X direction, the relative positional relationship between the first measurement device 33 and the leg part 11 is adjustable. As shown in FIGS. 1 and 2, the first measurement device 33 is mounted to a traveling platform 331. The first measurement device 33 may be removable from the traveling platform 331. The traveling platform 331 is movable in the X direction. The traveling platform 331 travels along a rail 332 extending in the X direction in the vicinity of the support frame 40, for example. With the movement of the traveling platform 331 in the X direction, the position of the first measurement device 33 relative to the leg part 11 in the X direction changes.

Referring to FIGS. 1 and 2, the control device 70 is a computer including, for example, a central processing unit (CPU), a main storage device, an auxiliary storage device, an input device, and an output device. The control device 70 is communicably connected directly or indirectly to the first measurement devices 31, 32, and 33. The control device 70 may be connected to the first measurement devices 31, 32, and 33 via an A/D converter (not shown), for example.

The control device 70 is also communicably connected to an excitation power supply (not shown). The excitation power supply supplies excitation current to the excitation coils included in the winding parts 20 in each of the leg parts 11 of the magnetic core 10. For example, as a result of an alternating-current voltage being applied to the excitation coils by the excitation power supply, excitation current flows through the excitation coils. The excitation power supply includes, for example, an arbitrary waveform generator and a power amplifier.

For example, a voltmeter (not shown) may be connected to the detection coils included in the winding parts 20 in each of the leg parts 11 of the magnetic core 10. In this case, the control device 70 may be communicably connected directly or indirectly to the voltmeter.

The control device 70 may be further communicably connected directly or indirectly to the second measurement device 80. The second measurement device 80 is configured to measure information on the magnetic core 10. The second measurement device 80 obtains information that is different from information obtained by the first measurement devices 31, 32, and 33. Examples of the second measurement device 80 include a temperature sensor, an accelerometer, and a strain gauge. The second measurement device 80 may be provided at an appropriate position relative to the magnetic core 10 according to the information to be measured. The evaluation apparatus 100 may include one or more second measurement devices 80.

### [Evaluation Method]

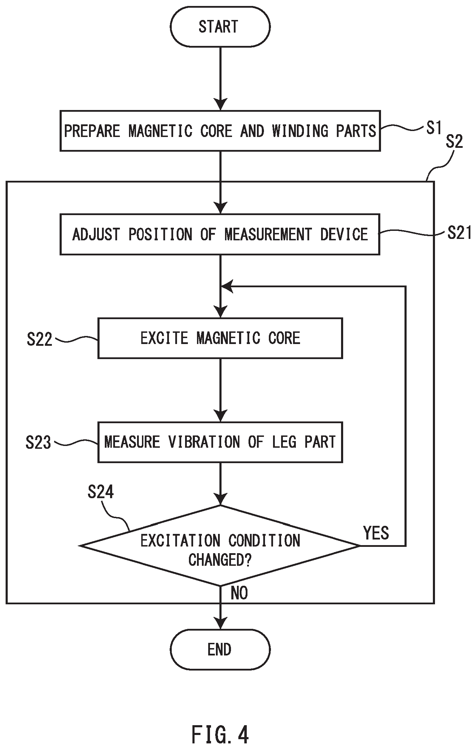

Next, an evaluation method using the evaluation apparatus 100 will be described with further reference to FIG. 4. FIG. 4 is a flowchart for illustrating the evaluation method according to this embodiment. In the evaluation method according to this embodiment, the vibration of the magnetic material that forms the magnetic core 10 is evaluated. The flowchart shown in FIG. 4 includes, in addition to steps performed by the evaluation apparatus 100, steps performed by an evaluator of the vibration of the magnetic material. As shown in FIG. 4, the evaluation method includes a preparing step S1 and a measuring step S2.

### (Preparing Step)

In the preparing step S1, a magnetic core 10 and a plurality of winding parts 20 are prepared (FIG. 3). The magnetic core 10 and the winding parts 20 are prepared by the evaluator. As described above, in the magnetic core 10 to be evaluated, two or more winding parts 20 are attached to at least one leg part 11. In the example of this embodiment, the magnetic core 10 and the winding parts 20 constitute a model of a three-phase alternating-current transformer.

### (Measuring Step)

In the measuring step S2, the magnetic core 10 is excited by excitation of the winding parts 20, and the vibration of the leg part 11 is measured by one or more of the first measurement devices 31, 32, and 33. In this embodiment, in order to facilitate understanding, attention is given to one leg part 11 included in the plurality of leg parts 11 included in the magnetic core 10, and the measuring step of the vibration of that leg part 11 will be described.

For the start of the measuring step S2, the evaluator adjusts the position of one or more of the first measurement devices 31, 32, and 33 relative to the leg part 11 to be measured (step S21). The first measurement devices 31, 32, and 33 may be manually moved by the evaluator, or may be automatically moved by controlling a movement mechanism by the control device 70. The first measurement devices 31, 32, and 33 are moved, for example, to positions corresponding to a gap G between the winding parts 20.

Next, excitation of the winding parts 20 attached to the leg part 11 is started by the evaluation apparatus 100, thus exciting the magnetic core 10 (step S22). Specifically, according to an operation performed by the evaluator, the control device 70 outputs a command signal to an excitation power supply (not shown), and the excitation power supply supplies excitation current to the excitation coils of the winding parts 20. The excitation power supply generates an excitation waveform based on the command signal from the control device 70, and generates excitation current to the excitation coils based on this excitation waveform. Excitation current may flow through the excitation coils, for example, by applying, to the excitation coils, an alternating-current voltage having the excitation waveform generated by the excitation power supply. The excitation waveform supplied to the excitation coils need not necessarily be a sine wave.

For example, the control device 70 reads output waveform information prepared in advance, and adjusts the excitation waveform based on the output waveform information. The output waveform information is, for example, magnetic flux waveform information of the magnetic core 10, or waveform information (detection waveform information) of the current or voltage in the detection coils. The output waveform information can be stored in advance in an auxiliary storage device or the like of the control device 70. The control device 70 outputs the information of the adjusted excitation waveform to the excitation power supply. The excitation power supply performs excitation of the winding parts 20 in accordance with the excitation waveform instructed to the control device 70. As a result of the excitation of the winding parts 20, a magnetic flux is generated in the leg part 11 of the magnetic core 10 with a waveform corresponding to the magnetic flux waveform information stored in advance, or current is generated in the detection coils of the winding parts 20 with a waveform corresponding to the detection waveform information stored in advance. The excitation waveform may be derived from the output waveform information of the magnetic flux waveform information or the detection waveform information, using a known calculation method.

In a state in which an alternating magnetic field is generated as a result of the magnetic core 10 having been excited, the vibration of the leg part 11 is measured (step S23). The measurement of the vibration is performed by one or more of the first measurement devices 31, 32, and 33.

The first measurement device 31 can measure the vibration of the leg part 11 in the out-plane direction (Z direction) through the gap G between the winding parts 20. No jig 50 is disposed in the gap G used for the measurement performed by the first measurement device 31. For example, when the first measurement device 31 is a laser Doppler vibrometer, the first measurement device 31 can emit a laser beam to the surface of the leg part 11 through the gap G between the winding parts 20, detect the reflected light, and measure the displacement of the leg part 11 in the Z direction.

The first measurement device 32 can measure the vibration of the leg part 11 in the in-plane direction (X direction) through the gap G between the winding parts 20. No jig 50 is disposed in the gap G used for the measurement performed by the first measurement device 32. For example, when the first measurement device 32 is a laser Doppler vibrometer, the first measurement device 32 emits a laser beam toward the leg part 11 through the gap G between the winding parts 20. In this case, for example, a reflector (not shown) made of plastic or the like is preferably attached onto the leg part 11. The first measurement device 32 detects the laser beam reflected by the reflector, and measures the displacement of the leg part 11 in the X direction.

The first measurement device 33 can measure the vibration of the leg part 11 in the in-plane direction (Y direction). For example, when the first measurement device 33 is a laser Doppler vibrometer, the first measurement device 33 emits a laser beam toward the leg part 11. In this case, a reflector (not shown) made of plastic or the like is preferably attached to the leg part 11. The laser beam can pass through the cut-out portions 52 and 64 of the jigs 50 and 60 to reach the reflector. The first measurement device 33 can detect the laser beam reflected by the reflector, and measure the displacement of the leg part 11 in the Y direction.

Vibration information of the leg part 11 is input to the control device 70 from one or more of the first measurement devices 31, 32, and 33. The vibration information is converted into a digital signal, for example, by an A/D converter, and the digital signal is transmitted to the control device 70. The control device 70 stores the input vibration information.

When an alternating magnetic field is generated as a result of the magnetic core 10 having been excited, the control device 70 may obtain, in addition to the vibration information, measurement information from the second measurement device 80.

When a plurality of excitation conditions prepared in advance exist, the evaluation apparatus 100 may change the excitation conditions in a state in which the positions of the first measurement devices 31, 32, and 33 are maintained, and perform the above-described measurement again (steps S24, S22, and S23). The plurality of excitation conditions are stored in advance, for example, in an auxiliary storage device or the like of the control device 70. By the CPU of the control device 70 executing a predetermined program, the measurement of the vibration can be performed while automatically varying the excitation conditions. The excitation conditions include frequencies and magnetic flux densities. The control device 70 performs excitation of the winding parts 20 in accordance with preset excitation conditions, including, for example, combinations of frequencies and magnetic flux densities, thus exciting the magnetic core 10. One or more of the first measurement devices 31, 32, and 33 measure the vibration of the leg part 11 for each excitation condition, and transmit the measured information to the control device 70. The evaluation apparatus 100 can repeat the measurement of the vibration of the leg part 11 while varying the excitation conditions, for example, until the prepared excitation conditions have been exhausted.

In this embodiment, the magnetic core 10 to be evaluated includes three leg parts 11, and the plurality of winding parts 20 are attached to each of the leg parts 11. The evaluator can change the connection method of the winding parts 20, and perform the measuring step S2. When each winding part 20 is provided with an excitation coil and a detection coil in each of the leg parts 11 as in this embodiment, the evaluator can switch the connection method for excitation coils and the connection method for detection coils. In the case of a model of a three-phase alternating-current transformer, connection methods that can be switched are typically delta connection and star connection. The evaluation apparatus 100 can measure vibration of the leg parts 11 regardless of the connection method.

### [Effects]

In general, a winding part is attached to a leg part (main leg) of a magnetic core without any gap. That is, the winding part is usually densely disposed on the leg part such that the leg part is not exposed. In contrast, in this embodiment, the plurality of winding parts 20 are attached to at least one leg part 11 of the magnetic core 10 with a gap G therebetween. The leg part 11 is exposed through the gap G between the winding parts 20. By using the gap G, it is possible to measure the vibration of the leg part 11 even in a range in which the winding parts 20 are provided.

In this embodiment, the vibration of the leg part 11 in the out-plane direction (Z direction) can be measured through the gap G between the winding parts 20 by the first measurement device 31. Also, the vibration of the leg part 11 in the in-plane direction (X direction) can be measured through the gap G between the winding parts 20 by the first measurement device 32. In addition to this, the vibration of the leg part 11 in the in-plane direction (Y direction) can also be measured by the first measurement device 33.

In this embodiment, the vibration (displacement) of the leg part 11 in the X, Y, and Z directions can be detected. From the displacement of the leg part 11 in the X, Y, and Z directions, the magnetostriction (displacement amount per unit length) of the leg part 11 in each of the X, Y, and Z directions can be calculated taking the size of the leg part 11 into account. Therefore, it is also possible to obtain the magnetostriction of the leg part 11.

In this embodiment, each of the first measurement devices 31, 32, and 33 is configured such that a position thereof relative to the leg part 11 to be measured is adjustable. Accordingly, the first measurement devices 31, 32, and 33 can measure and obtain the vibration of the leg part 11 at various positions.

In this embodiment, the plurality of winding parts 20 each include the excitation coil in at least one leg part 11 of the magnetic core 10. In the leg part 11, the excitation coils that are electrically connected in series are disposed with a gap G therebetween. In this case, using the gap G between the excitation coils, vibration can be measured at positions of a group of the excitation coils of the leg part 11 through which a large excitation current flows.

However, in the leg part 11, each of the winding parts 20 need not necessarily include the excitation coil. Each of the winding parts 20 may include only one of the excitation coil and the detection coil. For example, one or more winding parts 20 disposed on one side in the axial direction of the leg part 11 may include only the excitation coil, and one or more winding parts 20 disposed on the other side in the axial direction of the leg part 11 may include only the detection coil.

In this embodiment, the jig 50 may be provided in at least one gap G through which the leg part 11 is exposed. The jig 50 is disposed on the leg part 11 in the gap G, and fixes the leg part 11 to the evaluation apparatus 100. The jig 50 can apply compressive force to the leg part 11 from a surface thereof. This makes it possible to reproduce the force applied to the leg part 11 in actual use, and measure the vibration of the leg part 11.

In this embodiment, the jig 50 may include at least one cut-out portion 52. The cut-out portion 52 penetrates the jig 50 in the Y direction, and therefore allows, for example, a laser beam emitted from the first measurement device 33 and a reflected light thereof to pass therethrough. Accordingly, even in a state in which the jig 50 is disposed in the gap G between the winding parts 20, the vibration of the leg part 11 in the Y direction can be measured by the first measurement device 33 at a position beyond the jig 50.

In this embodiment, the magnetic core 10 may be fixed to the evaluation apparatus 100 with the jig 60. This makes it possible to tightly fasten the magnetic core 10 and measure the vibration of the leg part 11. The jig 60 may include at least one cut-out portion 64. The cut-out portion 64 penetrates the jig 60 in the Y direction, and therefore allows a laser beam emitted from the first measurement device 33 and reflected light thereof to pass therethrough, as in the case of the cut-out portion 52 of the jig 50. Therefore, the vibration of the leg part 11 in the Y direction can be measured by the first measurement device 33 without being obstructed by the jig 60.

The evaluation apparatus 100 according to this embodiment may be configured to adjust an excitation waveform based on output waveform information prepared in advance, and perform excitation of the winding parts 20 in accordance with the adjusted excitation waveform. The evaluation apparatus 100 can perform excitation of the winding parts 20 not only with a sine wave, but also with various desired excitation waveforms. For example, the excitation wave supplied to the excitation coil of the winding part 20 may be adjusted such that the magnetic flux waveform of the magnetic core 10, or the current or voltage waveform of the detection coil is a sine wave.

In this embodiment, information that is different from information measured by the first measurement devices 31, 32, and 33 may be measured for the magnetic core 10 by the second measurement device 80. These pieces of information are stored in the control device 70, for example. The evaluator can evaluate the vibration and the magnetostriction of the leg part 11 of the magnetic core 10, taking also into account, for example, the measurement information obtained by the second measurement device 80.

The evaluation apparatus 100 according to this embodiment may be configured to excite the magnetic core 10 while varying excitation conditions, and measure the vibration of the leg part 11 by one or more of the first measurement devices 31, 32, and 33 under each of the excitation conditions. These pieces of information are stored in the control device 70, for example. The evaluation apparatus 100 can obtain measurement information at the same measurement position and under different excitation conditions, for example, by measuring the vibration of the leg part 11 while varying the excitation conditions in a state in which the positions of the first measurement devices 31, 32, and 33 are maintained. The evaluator can combine the vibration information obtained under different excitation conditions, and evaluate the vibration and the magnetostriction of the leg part 11 of the magnetic core 10.

Although embodiments according to the present disclosure have been described above, the present disclosure is not limited to the above-described embodiments, and various alterations can be made without departing from the gist of the disclosure.

In the above-described embodiments, the evaluation apparatus 100 includes the plurality of first measurement devices 31, 32, and 33 in order to measure the vibration of the leg part 11 in three directions (X, Y, and Z directions). However, the evaluation apparatus 100 may include at least one of the first measurement devices 31, 32, and 33. For example, when the evaluation apparatus 100 includes only one first measurement device 31, the first measurement device 31 can be used only for measuring the vibration of the leg part 11 in the out-plane direction (Z direction), or the first measurement device 31 can be used also for measuring the vibration in the in-plane direction (X and Y directions) in addition to the out-plane direction. That is, the first measurement device 31 may be remounted, for example, from the traveling platform 312 to the traveling platform 321 or 331 for use. The same applies to the first measurement devices 32 and 33. The first measurement devices 32 and 33 can be used in any of the vibration measurements in the X, Y, and Z directions.

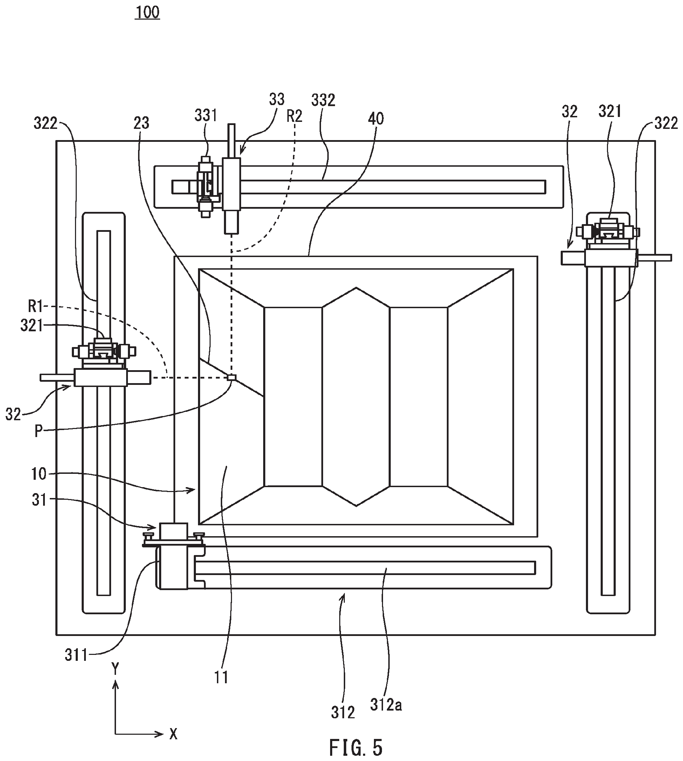

When the evaluation apparatus 100 includes two or more first measurement devices capable of measuring vibration, such as the first measurement devices 31, 32, and 33, the vibration of the leg part 11 can be simultaneously measured in two or more of the X, Y, and Z directions. For example, as shown in FIG. 5, the vibration of the leg part 11 at a measurement point P may be measured simultaneously by each of the first measurement devices 32 and 33. In order to simplify the illustration, the winding parts 20 and the jigs 50 and 60 have been omitted from FIG. 5.

Referring to FIG. 5, the first measurement devices 32 and 33 are capable of emitting laser beams to the measurement point P of the leg part 11 from different directions. Specifically, the first measurement device 32 is capable of emitting a laser beam to the measurement point P in the X direction, and the first measurement device 33 is capable of emitting a laser beam to the measurement point P in the Y direction. The measurement point P is a position corresponding to the gap G (FIGS. 1 to 3) between the winding parts 20 of the leg part 11. For example, a reflector is attached to the measurement point P of the leg part 11.

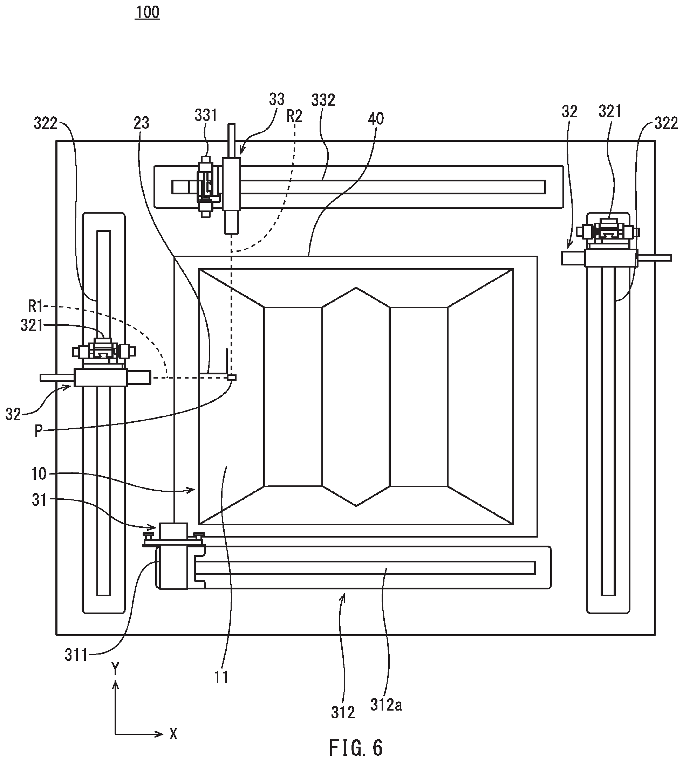

A light-blocking plate 23 may be provided between an emission path R1 of a laser beam from the first measurement device 32 to the measurement point P and an emission path R2 of a laser beam from the first measurement device 33 to the measurement point P. The light-blocking plate 23 is disposed adjacent to the measurement point P. For example, the light-blocking plate 23 is disposed next to the reflector on the leg part 11. In the example shown in FIG. 5, the light-blocking plate 23 has a linear shape as viewed in a direction (Z direction) perpendicular to both the emission paths R1 and R2 of the laser beams from the first measurement devices 32 and 33. However, as shown in FIG. 6, the light-blocking plate 23 may have a substantially L-shape as viewed in the direction perpendicular to both the emission paths R1 and R2. For example, the light-blocking plate 23 is disposed inside the bobbin 21 (FIG. 3) of the winding part 20. In the evaluation apparatus 100, one light-blocking plate 23, or a plurality of light-blocking plates 23 may be provided for the measurement point P.

The light-blocking plate 23 is a plate-shaped member for preventing interference between a laser beam emitted from the first measurement device 32 and a laser beam emitted from the first measurement device 33. By preventing interference between the laser beams directed from the first measurement devices 32 and 33 toward the measurement point P, it is possible to improve the measurement accuracy of measurement of vibration of the leg part 11 performed by each of the first measurement devices 32 and 33.

In the examples shown in FIGS. 5 and 6, the vibrations of the leg part 11 at the measurement point P in the X direction and the Y direction are measured simultaneously by the first measurement devices 32 and 33. However, the vibrations of the leg part 11 at the measurement point P in the Z direction and the Y direction may be simultaneously measured by the first measurement devices 31 and 33, or the vibrations of the leg part 11 at the measurement point P in the Z direction and the X direction may be simultaneously measured by the first measurement devices 31 and 32. Also, the vibration of the leg part 11 at the measurement point P in the Z direction, the X direction, and the Y direction may be simultaneously measured by the first measurement devices 31, 32, and 33. Also in these cases, the light-blocking plate 23 may be provided between the emission paths of laser beams from two or more first measurement devices so as to prevent interference between the laser beams emitted from the two or more first measurement devices toward the measurement point P.

Alternatively, the vibration of the leg part 11 in the same direction may be measured at plurality of locations by a plurality of first measurement devices. For example, when the vibration of the leg part 11 in the Y direction is measured at a plurality of locations, a plurality of first measurement devices are prepared, and reflectors are disposed on the surface of the leg part 11 at different position in the Y direction. Then, for example, by emitting laser beams from the corresponding first measurement devices to the respective reflectors, the vibration (displacement) of the leg part 11 in the Y direction can be measured at the respective positions. For example, by determining differences in vibration at a plurality of measurement positions, the elongation of the leg part 11 between the measurement positions can be obtained. Similarly, the vibration of the leg part 11 in the X direction and the Z direction can also be measured at a plurality of measurement positions.

Since the configuration of the evaluation apparatus 100 and the use method thereof are described together in the above-described embodiment, the evaluation apparatus 100 includes the magnetic core 10 to be evaluated. However, for example, at a timing, such as at the time of distribution of the evaluation apparatus 100, at which the vibration of the magnetic material has not been performed, the magnetic core 10 need not be installed in the evaluation apparatus 100. That is, the magnetic core 10 to be evaluated need not be attached to the winding parts 20 in advance. The evaluation apparatus 100 can include the plurality of winding parts 20, and at least one of the first measurement devices 31, 32, and 33. In this case, in the evaluation apparatus 100, the plurality of winding parts 20 are arranged with a gap therebetween in the axial direction of the winding parts 20.

In the above-described embodiment, the first measurement devices 31, 32, and 33 move in order to adjust the positional relationship between the leg part 11 to be measured and the first measurement devices 31, 32, and 33. However, it is sufficient that the relative positions of the first measurement devices 31, 32, and 33 to the leg part 11 can be adjusted, and it is also possible to move, for example, the support frame 40 that supports the magnetic core 10.

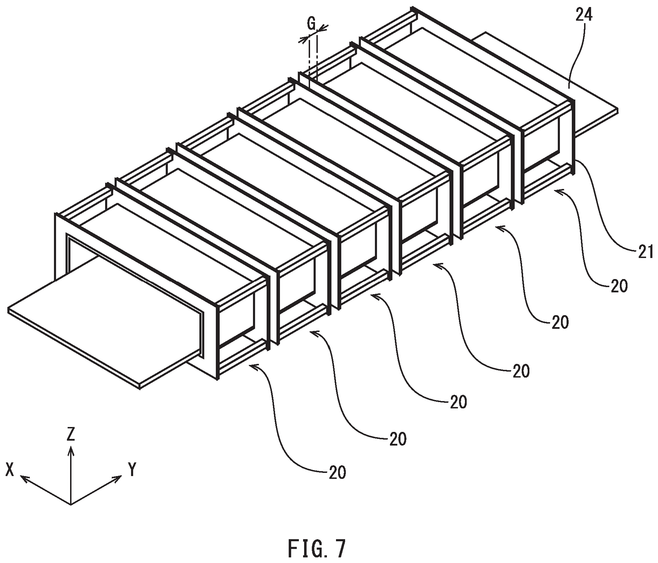

In the evaluation apparatus 100 according to the above-described embodiment, the winding parts 20 are arranged with the gap G therebetween in the axial direction thereof. Accordingly, when attaching the winding parts 20 to the leg part 11 of the magnetic core 10, the leg part 11 may be caught on the winding parts 20 at the position of the gap G, resulting in a longer time to attach the winding parts 20 to the leg part 11. For this reason, the evaluation apparatus 100 may include an underlay plate 24, as shown in FIG. 7. The underlay plate 24 is inserted inside the bobbins 21 of the winding parts 20, and extends in the direction of arrangement of the winding parts 20. In this case, the leg part 11 (FIG. 1) of the magnetic core 10 can be inserted into the winding parts 20 on the underlay plate 24. This can prevent the leg part 11 from being caught on the winding parts 20 at the position of the gap G, thus making it possible to smoothly attach the winding parts 20 to the leg part 11.

### REFERENCE SIGNS LIST

100: Evaluation apparatus
10: Magnetic core
11: Leg part
20: Winding part
22: Coil (excitation coil)
31, 32, 33: First measurement device
50: Jig
52: Cut-out portion
80: Second measurement device

## Claims

1. An evaluation apparatus for evaluating vibration of a magnetic material,
the evaluation apparatus comprising:
a magnetic core made of the magnetic material, and including a leg part;
a plurality of winding parts arranged with a gap therebetween in an axial direction of the leg part, attached to the leg part so as to expose the leg part through the gap, and configured to excite the magnetic core by excitation; and
a first measurement device that measures vibration of the leg part.

2. An evaluation apparatus for evaluating vibration of a magnetic material,
the evaluation apparatus comprising:
a plurality of winding parts arranged with a gap therebetween in an axial direction, and being attachable to a leg part of a magnetic core made of the magnetic material; and
a first measurement device for measuring vibration of the leg part.

3. The evaluation apparatus according to claim 1 or 2, wherein
each of the plurality of winding parts includes an excitation coil through which excitation current flows.

4. The evaluation apparatus according to claim 1 or 2, further comprising
a jig that is disposed on the leg part in the gap, and that fixes the leg part to the evaluation apparatus.

5. The evaluation apparatus according to claim 4, wherein
the jig includes a cut-out portion formed on a surface thereof that opposes the leg part, and penetrating the jig in the axial direction.

6. The evaluation apparatus according to claim 1 or 2, wherein
the first measurement device is a laser Doppler vibrometer.

7. The evaluation apparatus according to claim 1 or 2, comprising
a plurality of the first measurement devices, wherein
each of the first measurement devices is configured such that a position thereof relative to the leg part is adjustable.

8. The evaluation apparatus according to claim 1 or 2, wherein
the evaluation apparatus is configured to adjust an excitation waveform based on output waveform information prepared in advance, and perform excitation of the winding parts in accordance with the excitation waveform.

9. The evaluation apparatus according to claim 1 or 2, further comprising
a second measurement device that measures information that is different from information measured by the first measurement device for the magnetic core.

10. The evaluation apparatus according to claim 1 or 2, wherein
the evaluation apparatus is configured to excite the magnetic core while varying excitation conditions, and measure vibration of the leg part by the first measurement device under each of the excitation conditions.

11. The evaluation apparatus according to claim 1 or 2, comprising
two said first measurement devices, wherein
the first measurement devices are capable of emitting laser beams to a measurement point of the leg part from different directions, and,
between an emission path of a laser beam from one of the first measurement devices to the measurement point and an emission path of a laser beam from the other of the first measurement devices to the measurement point, a light-blocking plate for preventing interference between the laser beam emitted from the one of the first measurement devices and the laser beam emitted from the other of the first measurement devices is provided adjacent to the measurement point.

12. An evaluation method for evaluating vibration of a magnetic material, the method comprising the steps of:
preparing a magnetic core made of the magnetic material and including a leg part, and a plurality of winding parts arranged with a gap therebetween in an axial direction of the leg part, and attached to the leg part so as to expose the leg part through the gap; and
exciting the magnetic core by excitation of the winding part, and measuring vibration of the leg part by a measurement device.

13. The evaluation method according to claim 12, wherein,
in the measuring step, vibration of the leg part is measured by the measurement device through the gap.

14. The evaluation method according to claim 12, wherein
the magnetic core includes three said leg parts to which the plurality of winding parts are respectively attached, and
connection methods of the winding parts are changed between the leg parts.
